# EUROPEAN PATENT APPLICATION

(11) **EP 3 886 544 A1**
(43) Date of publication of application: **29.09.2021**
(21) Application number: 20165860.6
(22) Date of filing: 26.03.2020
(51) Int. Cl.: H05K 5/00, H05K 7/14, H05K 5/04, H05K 7/20

(54) **ELECTRONICS ENCLOSURE**

(71) Applicant: ABB Schweiz AG, 5400 Baden (CH)
(72) Inventor: Nygren, Toni, 00380 Helsinki (FI); Ikäheimo, Ilmari, 00380 Helsinki (FI); Kohvakka, Mikko, 00380 Helsinki (FI)
(74) Representative: Kolster Oy Ab

(57) **Abstract**

The invention relates to the field of enclosures for electronics and electrical components within electric devices, such as electric drive devices for industrial applications, and more particularly to an electronics enclosure. The electronics enclosure (1) according to the present invention comprises a cover enclosure part (20); a base enclosure part (10); and a first side enclosure part (30) and a second side enclosure part (40), wherein said base enclosure part (10) and said cover enclosure part (20) are extruded profile parts, and wherein said cover enclosure part (20) is pivotably connectable to said base enclosure part (10) and detachable from said base enclosure part (10).

## Description

### FIELD OF THE INVENTION

The present invention relates to the field of enclosures for electronics and electrical components within electric devices, such as electric drive devices for industrial applications, and more particularly to an electronics enclosure.

### BACKGROUND OF THE INVENTION

Electric devices, such as electric drive devices, are widely used for industrial applications, e.g. for providing and controlling electrical power and energy to various public and industrial applications as well as for driving and controlling various public and industrial applications. These applications include devices for transport vehicle engines, different process and manufacturing technological devices, and devices in energy industry as well as industrial electric drives.

Industrial electric drives are used for various applications, such as transport vehicle engines, different process and manufacturing technological devices and in energy industry. As regards transport devices, electric drives may be used in underground railway service or shipping service, for example. In process and manufacturing technology electric drives may be used e.g. in conveyors, mixers or in paper machines, for instance. In energy industry, electric drives may be used in turbines of wind power industry or in solar power industry, for example.

Typically, electric devices, such as electric drive devices, have steel sheet enclosures for shielding electronics and electrical components, such as steel sheet enclosures for shielding control unit electronics. The prior art electronics enclosures are typically heavy and hard to handle.

The assembly process of the prior art electronics enclosures is usually very complex, troublesome and time consuming due to difficult angles and multiple screw connections.

There are also problems with prior art electronics enclosures in the servicing and maintenance of an electric device. Furthermore, the prior art electronics enclosures have unsatisfactory vibration durability

Consequently, there is clearly a need and demand for an electronics enclosure that allows a straightforward and easy installation and provides a better vibration durability.

### BRIEF DESCRIPTION OF THE INVENTION

The object of the invention is to introduce an electronics enclosure, which provides a straightforward and easy installation and a good vibration durability. Advantageous embodiments are furthermore presented.

It is brought forward a new electronics enclosure, which electronics enclosure comprises a cover enclosure part; a base enclosure part; and a first side enclosure part and a second side enclosure part, wherein said base enclosure part and said cover enclosure part are extruded profile parts, and wherein said cover enclosure part is pivotably connectable to said base enclosure part and detachable from said base enclosure part. Hereby, one or more of the above-mentioned advantages and/or objectives are achieved. These advantages and/or objectives are further facilitated with the additional preferred features and/or steps described in the following.

In a preferred embodiment, said first side enclosure part and said second side enclosure part are fastenable to said base enclosure part and to said cover enclosure part with screws.

In a preferred embodiment, said base enclosure part and/or said cover enclosure part comprise one or more groove parts for fastening said first side enclosure part and/or said second side enclosure part.

In a preferred embodiment, said base enclosure part comprises a first hinge joint part and said cover enclosure part comprises a matching second hinge joint part so that said first hinge joint part and said second hinge joint part together form a detachable hinge joint.

In a preferred embodiment, said base enclosure part comprises a first snap joint part and said cover enclosure part comprises a matching second snap joint part so that said first hinge joint part and said second hinge joint part together form an openable/closable snap joint.

In a preferred embodiment, said base enclosure part is arranged for assembling of electronics components.

In a preferred embodiment, said electronics components comprise one or more circuit boards and other electronics components assemblable on said one or more circuit boards.

In a preferred embodiment, said base enclosure part and/or said cover enclosure part comprise one or more openings.

In a preferred embodiment, said one or more openings comprise openings for cooling of said one or more circuit boards and/or said other electronics components.

In a preferred embodiment, said one or more openings comprise openings for switches and/or connectors and/or openings for indicator lights and/or light guides of said electronics components.

In a preferred embodiment, said one or more openings comprise openings fitted for cooling of particular electronics components.

In a preferred embodiment, said one or more openings comprise openings fitted for connecting one or more heatsink-equipped components to said base enclosure part and/or said cover enclosure part for conducting heat from said one or more heatsink-equipped components to said base enclosure part and/or said cover enclosure part.

In a preferred embodiment, an at least one thermal interface cylinder is connected to said cover enclosure part and/or to said base enclosure part (10) for conducting heat from said electronics components to said cover enclosure part and/or to said base enclosure part.

In a preferred embodiment, an at least one thermal interface sheet and/or thermal grease is adhered/applied to said thermal interface cylinder and/or to said cover enclosure part and/or to said base enclosure part.

In a preferred embodiment, said base enclosure part comprises a mounting protrusion.

### BRIEF DESCRIPTION OF THE DRAWINGS

In the following, the present invention will be described in more detail by way of example and with reference to the attached drawings, in which:
Figure 1 illustrates a perspective front view of an electronics enclosure according to one embodiment of the present invention.
Figure 2 illustrates an exploded perspective front view of an electronics enclosure according to one embodiment of the present invention.
Figure 3 illustrates a side view of detached electronics enclosure assembly parts of the electronics enclosure according to one embodiment of the present invention.
Figure 4 illustrates a side view of electronics enclosure assembly parts of the electronics enclosure joined from the hinge according to one embodiment of the present invention.
Figure 5 illustrates a side view of electronics enclosure assembly parts of the electronics enclosure joined from the hinge and snapped together according to one embodiment of the present invention.
Figure 6 illustrates a perspective front view of detached electronics enclosure assembly parts of the electronics enclosure according to one embodiment of the present invention.
Figure 7 illustrates a perspective front view of electronics enclosure assembly parts of the electronics enclosure joined from the hinge according to one embodiment of the present invention.
Figure 8 illustrates a perspective front view of electronics enclosure assembly parts of the electronics enclosure joined from the hinge and snapped together according to one embodiment of the present invention.
Figure 9 illustrates a perspective front view of a base enclosure part of the electronics enclosure with assembled electronics components according to one embodiment of the present invention.
Figure 10 illustrates perspective front view of a base enclosure part with assembled electronics components and a cover enclosure part of the electronics enclosure joined from the hinge according to one embodiment of the present invention.
Figure 11 illustrates a perspective front view of a base enclosure part with assembled electronics components and a cover enclosure part of the electronics enclosure joined from the hinge and snapped together according to one embodiment of the present invention.
Figure 12 illustrates a perspective front view of an electronics enclosure with assembled electronics components according to one embodiment of the present invention.
Figure 13 illustrates a perspective rear view of an electronics enclosure with assembled electronics components according to one embodiment of the present invention.
Figure 14 illustrates a detailed view of a base enclosure part of the electronics enclosure with exploded view parts of a thermal interface arrangement according to one embodiment of the present invention.
Figure 15 illustrates a detailed view of a base enclosure part of the electronics enclosure with an assembled thermal interface arrangement according to one embodiment of the present invention.
Figure 16 illustrates a side view of a base enclosure part with assembled electronics components and a cover enclosure part with an assembled thermal interface arrangement of the electronics enclosure joined from the hinge according to one embodiment of the present invention.
Figure 17 illustrates a side view of a base enclosure part with assembled electronics components and a cover enclosure part with an assembled thermal interface arrangement of the electronics enclosure joined from the hinge and snapped together according to one embodiment of the present invention.

The foregoing aspects, features and advantages of the invention will be apparent from the drawings and the detailed description related thereto.

### DETAILED DESCRIPTION

The electronics enclosure according to one embodiment of the present invention comprises a cover enclosure part, a base enclosure part, a first side enclosure part and a second side enclosure part, wherein said base enclosure part and sad cover enclosure part are extruded profile parts, and wherein said cover enclosure part is pivotably connectable to said base enclosure part and detachable from said base enclosure part.

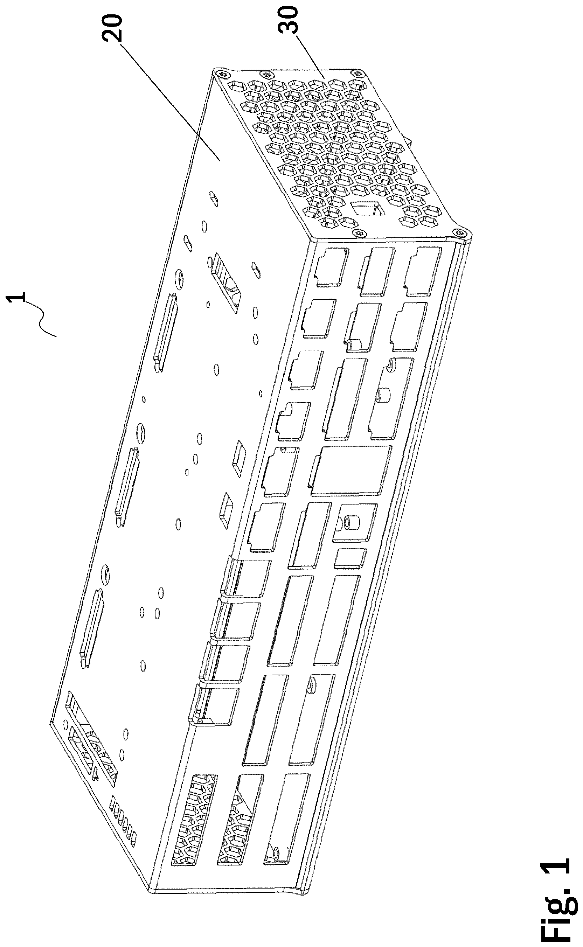

Figure 1 illustrates a perspective front view of an electronics enclosure according to one embodiment of the present invention. In the presented embodiment, there is illustrated an electronics enclosure 1 consisting of two extruded profile parts and two side enclosure parts. In Figure 1, a cover enclosure part 20 and a first side enclosure part 30 of said electronics enclosure 1 are shown. Said extruded profile parts may be made from any kind of material suitable for extrusion and having a good thermal conductivity, e.g. from a material comprising aluminium, aluminium alloy, magnesium, copper, brass, plastic, polymer, polymer alloy or synthetic resin.

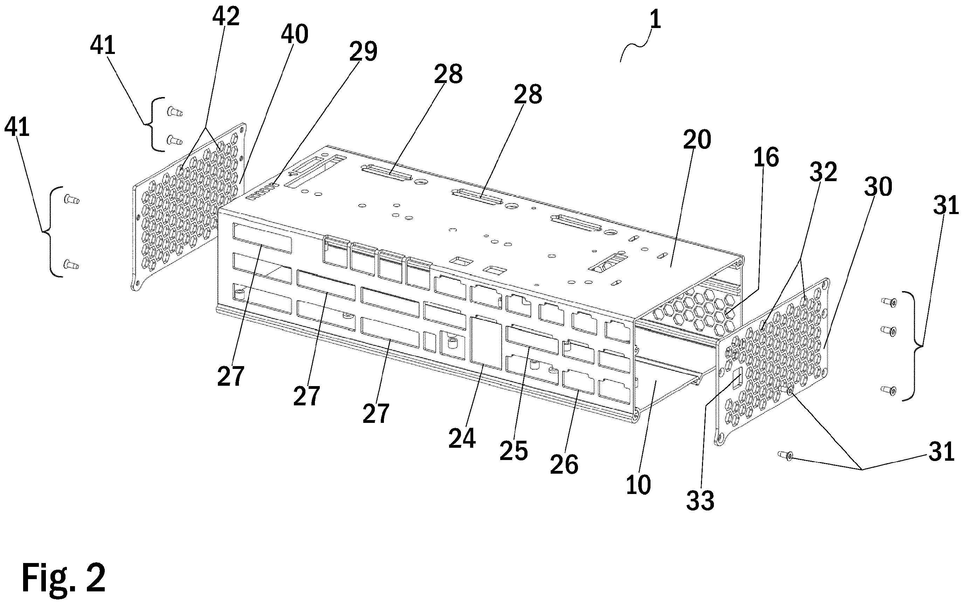

Figure 2 illustrates an exploded perspective front view of an electronics enclosure according to one embodiment of the present invention. In the presented embodiment, there is illustrated an electronics enclosure 1 consisting of a base enclosure part 10, a cover enclosure part 20, a first side enclosure part 30 and a second side enclosure part 40. In the presented embodiment, said base enclosure part 10 and said cover enclosure part 20 are extruded profile parts. Said base enclosure part 10 and said cover enclosure part 20 may be made from any kind of material suitable for extrusion and having a good thermal conductivity, e.g. from a material comprising aluminium, aluminium alloy, magnesium, copper, brass, plastic, polymer, polymer alloy or synthetic resin.

In the presented embodiment, the base enclosure part 10 and the cover enclosure part 20 of said electronics enclosure 1 may be assembled together to form an electronics enclosure assembly of the base enclosure part 10 and the cover enclosure part 20. After assembling said base enclosure part 10 and said cover enclosure part 20 together, the first side enclosure part 30 can be fastened with screws 31 to said electronics enclosure assembly of the base enclosure part 10 and the cover enclosure part 20. Similarly, the second side enclosure part 40 can be fastened with screws 41 to said electronics enclosure assembly of the base enclosure part 10 and the cover enclosure part 20.

In the presented embodiment, the base enclosure part 10 of said electronics enclosure 1 may comprise one or more openings 16. The base enclosure part 10 of said electronics enclosure 1 may comprise one or more openings 16. Said one or more openings 16 of the base enclosure part 10 may comprise openings 16 for cooling of the electronics boards and the electronics components. Said one or more openings 16 of the base enclosure part 10 may comprise openings 16 for switches and/or connectors of the electronics. Said one or more openings 16 of the base enclosure part 10 may also comprise openings 16 for indicator lights and/or light guides of the electronics.

Likewise, the cover enclosure part 20 of said electronics enclosure 1 may comprise one or more openings 24-29. Said one or more openings 24-29 of the cover enclosure part 20 may comprise openings 24-29 for cooling of the electronics boards and the electronics components. Said one or more openings 24-29 of the cover enclosure part 20 may comprise openings 24-29 for switches and/or connectors of the electronics. Said one or more openings 24-29 of the cover enclosure part 20 may also comprise openings 29 for indicator lights and/or light guides of the electronics.

Furthermore, the first side enclosure part 30 may comprise one or more openings 32, 33. Said one or more openings 32, 33 of the first side enclosure part 30 may comprise openings 32, 33 for cooling of the electronics boards and the electronics components. Said one or more openings 32, 33 of the first side enclosure part 30 may comprise openings 32, 33 for switches and/or connectors of the electronics. Likewise, the second side enclosure part 40 may comprise one or more openings 42. Said one or more openings 42 of the second side enclosure part 40 may comprise openings 42 for cooling of the electronics boards and the electronics components. Said one or more openings 42 of the second side enclosure part 40 may comprise openings 42 for switches and/or connectors of the electronics.

In the presented embodiment, said cover enclosure part 20 is pivotably connectable to said base enclosure part 10 and detachable from said base enclosure part 10.

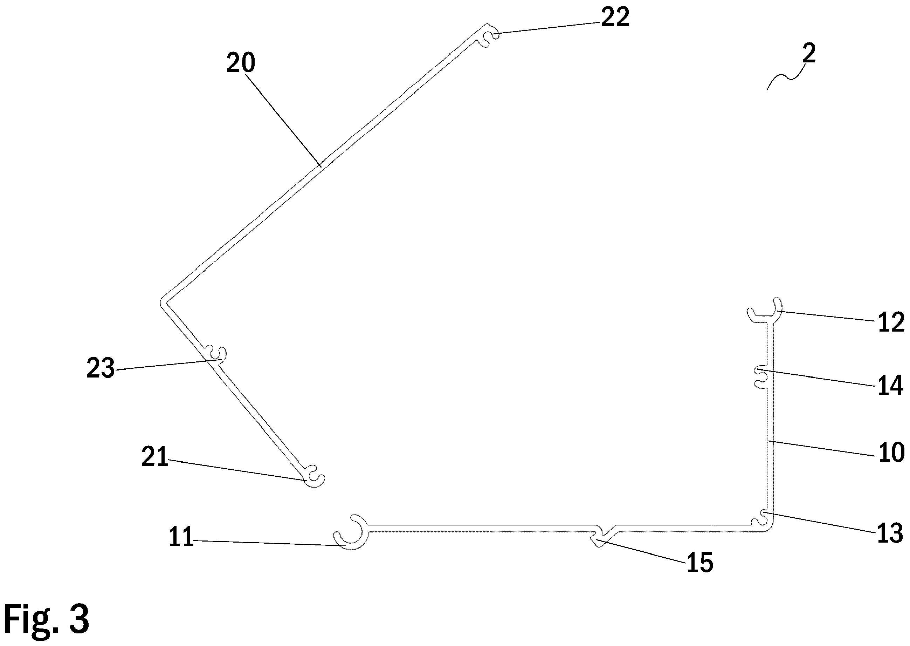

Figure 3 illustrates a side view of detached electronics enclosure assembly parts of the electronics enclosure according to one embodiment of the present invention. In the presented embodiment, the base enclosure part 10 of the electronics enclosure assembly 2 is shown in the lower right side and the cover enclosure part 20 of the electronics enclosure assembly 2 is shown in the upper left side. In the presented embodiment, said base enclosure part 10 and said cover enclosure part 20 are extruded profile parts. The extrusion profiles of said base enclosure part 10 and said cover enclosure part 20 are shown in Figure 3. As shown in Figure 3, the cover enclosure part 20 is detached from the base enclosure part 10.

In the presented embodiment, the base enclosure part 10 comprises a first hinge joint part 11 and a first snap joint part 12. Said first hinge joint part 11 and/or said first snap joint part 12 may be used as a groove part for fastening said first side enclosure part 30 or said second side enclosure part 40. Respectively, in the presented embodiment, the cover enclosure part 20 comprises a second hinge joint part 21 and a second snap joint part 22. Said second hinge joint part 21 and/or said second snap joint part 22 may be used as a groove part for fastening said first side enclosure part 30 or said second side enclosure part 40. In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. As used herein the terms "openable/closable snap joint" and "snap joint part" refer to any openable/closable joints and openable/closable joint securing means, where the joining parts can be joint together and detached from one another without excessive force, said openable/closable joint securing means including openable/closable snap-fit joints, snap-fit joint parts, openable/closable clamp joints and openable/closable spring-loaded elements, e.g. spring plunger joints.

In the presented embodiment, the base enclosure part 10 also comprises one or more groove parts 11, 12, 13, 14, which one or more groove parts 11, 12, 13, 14 may be used for fastening said first side enclosure part 30 or said second side enclosure part 40. Both sides of said one or more groove parts 11, 12, 13, 14 may be threaded for the screws provided for fastening said first side enclosure part 30 or said second side enclosure part 40.

Respectively, in the presented embodiment, the cover enclosure part 20 also comprises one or more groove parts 21, 22, 23, which one or more groove parts 21, 22, 23 may be used for fastening said first side enclosure part 30 or said second side enclosure part 40. Both sides of said one or more groove parts 21, 22, 23 may be threaded for the screws provided for fastening said first side enclosure part 30 or said second side enclosure part 40.

Furthermore, base enclosure part 10 of said electronics enclosure according to the presented embodiment also comprises a mounting protrusion 15, preferably a DIN-rail mounting protrusion 15, for facilitating easy mounting of said electronics enclosure.

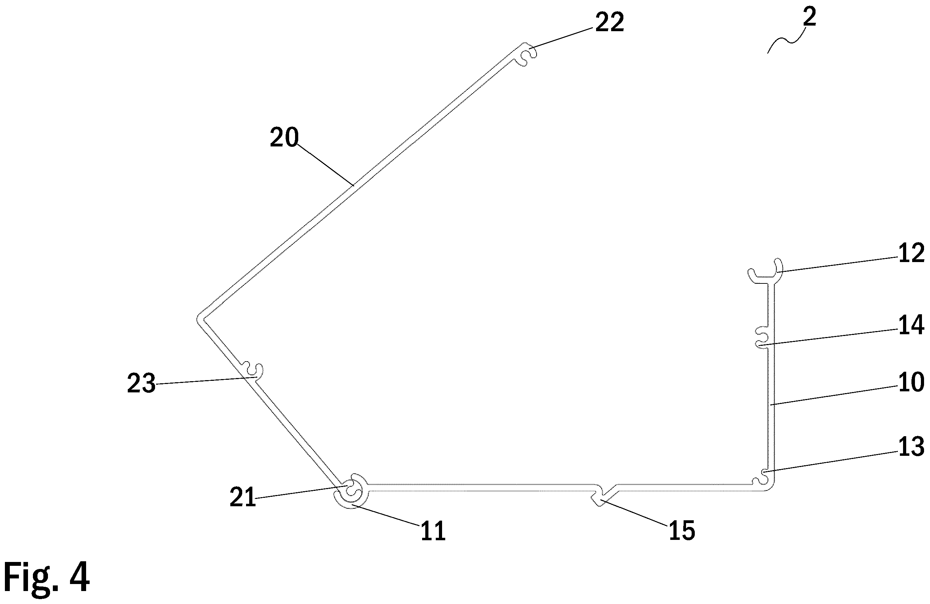

Figure 4 illustrates a side view of electronics enclosure assembly parts of the electronics enclosure joined from the hinge according to one embodiment of the present invention. In the presented embodiment, the base enclosure part 10 of said electronics enclosure assembly 2 comprises a first hinge joint part 11 and a first snap joint part 12. Respectively, in the presented embodiment, the cover enclosure part 20 of said electronics enclosure assembly 2 comprises a second hinge joint part 21 and a second snap joint part 22.

In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. As shown in Figure 4, the second hinge joint part 21 of the cover enclosure part 20 is joined with the first hinge joint part 11 of the base enclosure part 10. The cover enclosure part 20 is now supported to the base enclosure part 10 from the hinge joint 11, 21 so that the cover enclosure part 20 can now be turned in relation to the base enclosure part 10.

In the presented embodiment, said second hinge joint part 21 and/or said second snap joint part 22 may be used as a groove part for fastening said first side enclosure part 30 or said second side enclosure part 40. In the presented embodiment, the base enclosure part 10 also comprises one or more groove parts 13, 14, which may be used for fastening said first side enclosure part 30 or said second side enclosure part 40. Respectively, in the presented embodiment, the cover enclosure part 20 also comprises one or more groove parts 21, 22, 23, which may be used for fastening said first side enclosure part 30 or said second side enclosure part 40. Furthermore, base enclosure part 10 of said electronics enclosure according to the presented embodiment also comprises a mounting protrusion 15, preferably a DIN-rail mounting protrusion 15, for facilitating easy mounting of said electronics enclosure.

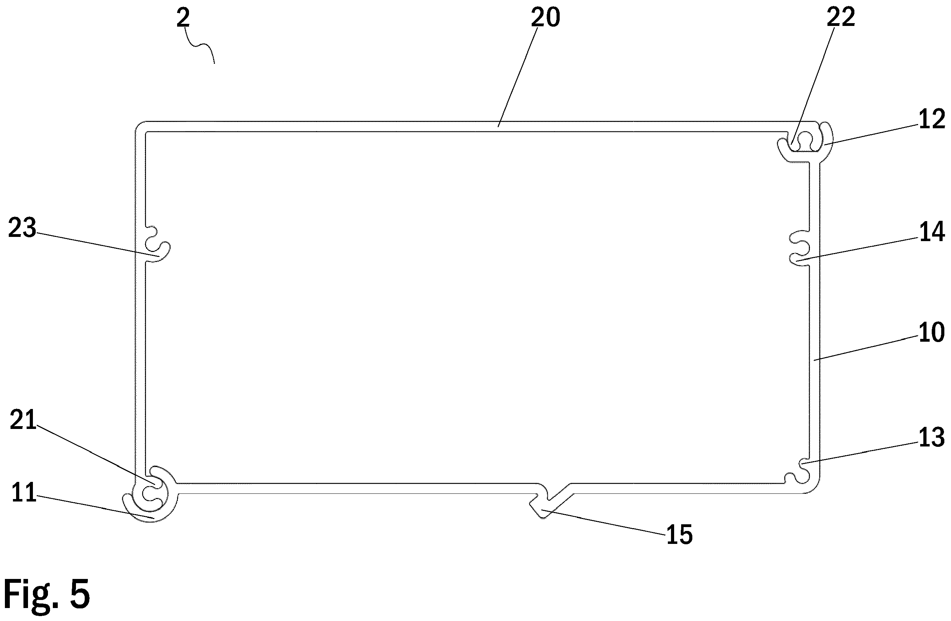

Figure 5 illustrates a side view of electronics enclosure assembly parts of the electronics enclosure joined from the hinge and snapped together according to one embodiment of the present invention. In the presented embodiment, the base enclosure part 10 of said electronics enclosure assembly 2 comprises a first hinge joint part 11 and a first snap joint part 12. Respectively, in the presented embodiment, the cover enclosure part 20 of said electronics enclosure assembly 2 comprises a second hinge joint part 21 and a second snap joint part 22.

In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. As shown in Figure 5, the second hinge joint part 21 of the cover enclosure part 20 is joined with the first hinge joint part 11 of the base enclosure part 10. Furthermore, the cover enclosure part 20 is turned in relation to the base enclosure part 10 and said enclosure parts 10, 20 are snapped together by joining said first snap joint part 12 and said second snap joint part 22 together.

The base enclosure part 10 and the cover enclosure part 20 of said electronics enclosure are now assembled together to form an electronics enclosure assembly 2 of the base enclosure part 10 and the cover enclosure part 20. The first side enclosure part 30 and the second side enclosure part 40 can now be fastened with screws 31, 41 to said electronics enclosure assembly of base enclosure part 10 and cover enclosure part 20.

In the presented embodiment, said second hinge joint part 21 and/or said second snap joint part 22 may be used as a groove part for fastening said first side enclosure part 30 or said second side enclosure part 40. In the presented embodiment, the base enclosure part 10 also comprises one or more groove parts 13, 14, which may be used for fastening said first side enclosure part 30 or said second side enclosure part 40. Respectively, in the presented embodiment, the cover enclosure part 20 also comprises one or more groove parts 21, 22, 23, which may be used for fastening said first side enclosure part 30 or said second side enclosure part 40. Furthermore, base enclosure part 10 of said electronics enclosure according to the presented embodiment also comprises a mounting protrusion 15, preferably a DIN-rail mounting protrusion 15, for facilitating easy mounting of said electronics enclosure.

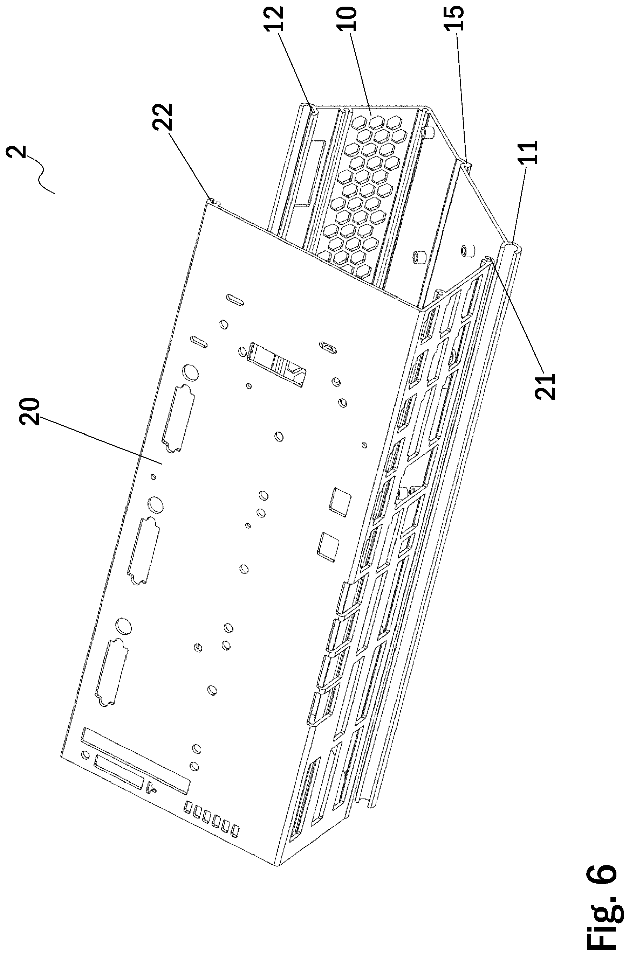

Figure 6 illustrates a perspective front view of detached electronics enclosure assembly parts of the electronics enclosure according to one embodiment of the present invention. In the presented embodiment, the base enclosure part 10 of the electronics enclosure assembly 2 is shown in the lower right side and the cover enclosure part 20 of the electronics enclosure assembly 2 is shown in the upper left side. As shown in Figure 6, the cover enclosure part 20 is detached from the base enclosure part 10.

In the presented embodiment, the base enclosure part 10 comprises a first hinge joint part 11 and a first snap joint part 12. Respectively, in the presented embodiment, the cover enclosure part 20 comprises a second hinge joint part 21 and a second snap joint part 22. In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. Furthermore, base enclosure part 10 of said electronics enclosure according to the presented embodiment also comprises a mounting protrusion 15, preferably a DIN-rail mounting protrusion 15, for facilitating easy mounting of said electronics enclosure.

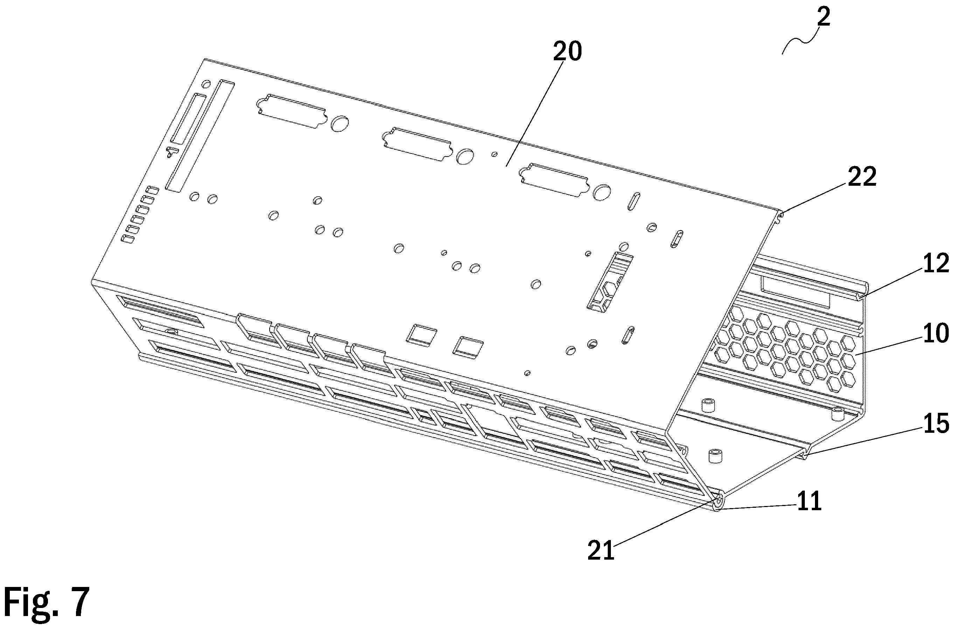

Figure 7 illustrates a perspective front view of electronics enclosure assembly parts of the electronics enclosure joined from the hinge according to one embodiment of the present invention. In the presented embodiment, the base enclosure part 10 of said electronics enclosure assembly 2 comprises a first hinge joint part 11 and a first snap joint part 12. Respectively, in the presented embodiment, the cover enclosure part 20 of said electronics enclosure assembly 2 comprises a second hinge joint part 21 and a second snap joint part 22. In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. Furthermore, base enclosure part 10 of said electronics enclosure according to the presented embodiment also comprises a mounting protrusion 15, preferably a DIN-rail mounting protrusion 15, for facilitating easy mounting of said electronics enclosure.

As shown in Figure 7, the second hinge joint part 21 of the cover enclosure part 20 is joined with the first hinge joint part 11 of the base enclosure part 10. The cover enclosure part 20 is now supported to the base enclosure part 10 from the hinge joint 11, 21 so that the cover enclosure part 20 can now be turned in relation to the base enclosure part 10.

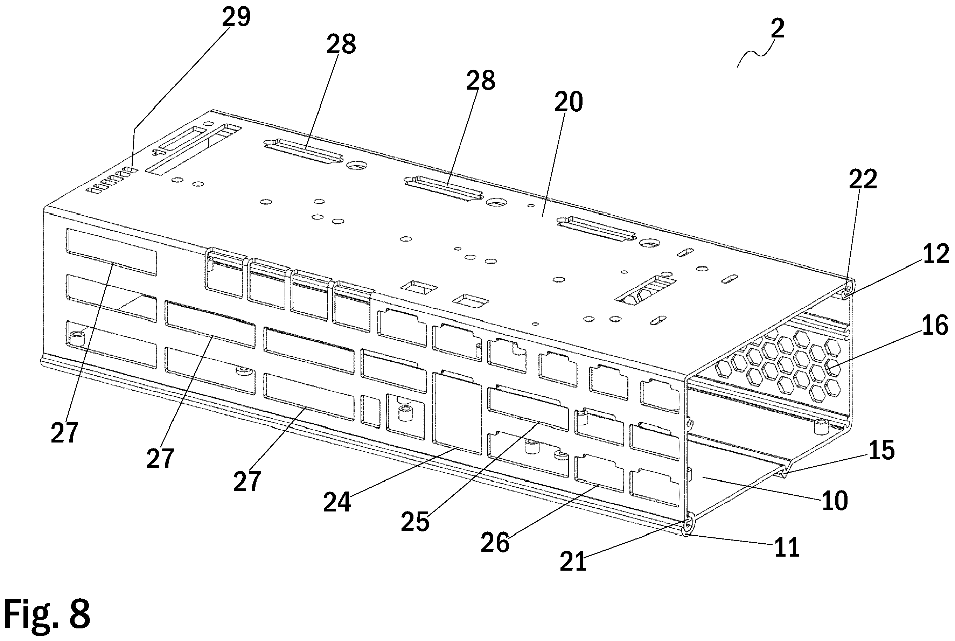

Figure 8 illustrates a perspective front view of electronics enclosure assembly parts of the electronics enclosure joined from the hinge and snapped together according to one embodiment of the present invention. In the presented embodiment, the base enclosure part 10 of said electronics enclosure assembly 2 comprises a first hinge joint part 11 and a first snap joint part 12. Respectively, in the presented embodiment, the cover enclosure part 20 of said electronics enclosure assembly 2 comprises a second hinge joint part 21 and a second snap joint part 22. In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. Furthermore, base enclosure part 10 of said electronics enclosure according to the presented embodiment also comprises a mounting protrusion 15, preferably a DIN-rail mounting protrusion 15, for facilitating easy mounting of said electronics enclosure.

As shown in Figure 8, the second hinge joint part 21 of the cover enclosure part 20 is joined with the first hinge joint part 11 of the base enclosure part 10. Furthermore, the cover enclosure part 20 is turned in relation to the base enclosure part 10 and said enclosure parts 10, 20 are snapped together by joining said first snap joint part 12 and said second snap joint part 22 together.

The base enclosure part 10 and the cover enclosure part 20 of said electronics enclosure are now assembled together to form an electronics enclosure assembly 2 of the base enclosure part 10 and the cover enclosure part 20. The first side enclosure part 30 and the second side enclosure part 40 can now be fastened with screws 31, 41 to said electronics enclosure assembly of base enclosure part 10 and cover enclosure part 20.

In the presented embodiment, said cover enclosure part 20 is pivotably connectable to said base enclosure part 10 and detachable from said base enclosure part 10. In the presented embodiment, said base enclosure part 10 and said cover enclosure part 20 are extruded profile parts. Said base enclosure part 10 and said cover enclosure part 20 may be made from any kind of material suitable for extrusion and having a good thermal conductivity, e.g. from a material comprising aluminium, aluminium alloy, magnesium, copper, brass, plastic, polymer, polymer alloy or synthetic resin.

In the presented embodiment, said base enclosure part 10 of said electronics enclosure assembly 2 may comprise one or more openings 16. Said one or more openings 16 of the base enclosure part 10 may comprise openings 16 for cooling of the electronics boards and the electronics components. Said one or more openings 16 of the base enclosure part 10 may comprise openings 16 for switches and/or connectors of the electronics. Said one or more openings 16 of the base enclosure part 10 may also comprise openings 16 for indicator lights and/or light guides of the electronics.

Likewise, the cover enclosure part 20 of said electronics enclosure assembly 2 may comprise one or more openings 24-29. Said one or more openings 24-29 of the cover enclosure part 20 may comprise openings 24-29 for cooling of the electronics boards and the electronics components. Said one or more openings 24-29 of the cover enclosure part 20 may comprise openings 28 for switches and/or connectors of the electronics components. Said one or more openings 24-29 of the cover enclosure part 20 may also comprise openings 29 for indicator lights and/or light guides of the electronics. One portion of said one or more openings 24-29 may comprise openings 24-26 fitted for cooling of particular electronics components. Another portion of said one or more openings 24-29 may comprise openings 27 fitted for connecting one or more heatsink-equipped components to said cover enclosure part 20 for conducting the heat from the heatsink-equipped components to said cover enclosure part 20.

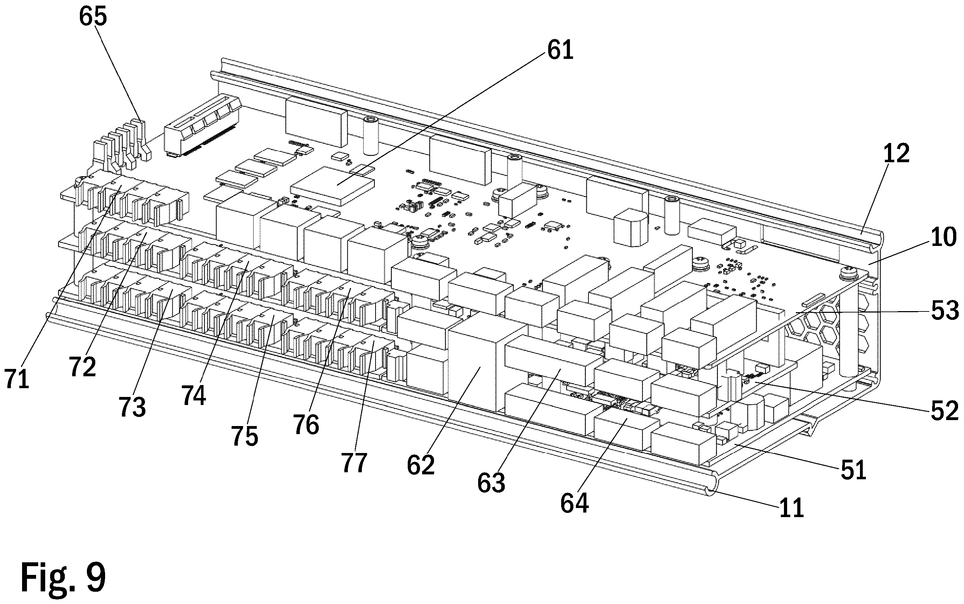

Figure 9 illustrates a perspective front view of a base enclosure part of the electronics enclosure with assembled electronics components according to one embodiment of the present invention. In the presented embodiment, the base enclosure part 10 comprises a first hinge joint part 11 and a first snap joint part 12.

In the presented embodiment, said base enclosure part 10 is arranged for assembling of electronics components 51-53, 61-65, 71-77. In the presented embodiment, electronics components 51-53, 61-65, 71-77 have been assembled to the base enclosure part 10. Said assembled electronics components 51-53, 61-65, 71-77 may comprise one or more circuit boards 51-53 and other electronics components 61-65, 71-77 assembled on said one or more circuit boards 51-53. Said other electronics components 61-65, 71-77 may comprise one or more high thermal load components 61 having a high thermal load. Said one or more high thermal load components 61 may include a processor 61 and/or power supply related components. Said other electronics components 61-65, 71-77 may comprise one or more heatsink-equipped components 71-77 being equipped with a heatsink. Said other electronics components 61-65, 71-77 may comprise one or more indicator lights 65 and/or light guides 65 of the electronics.

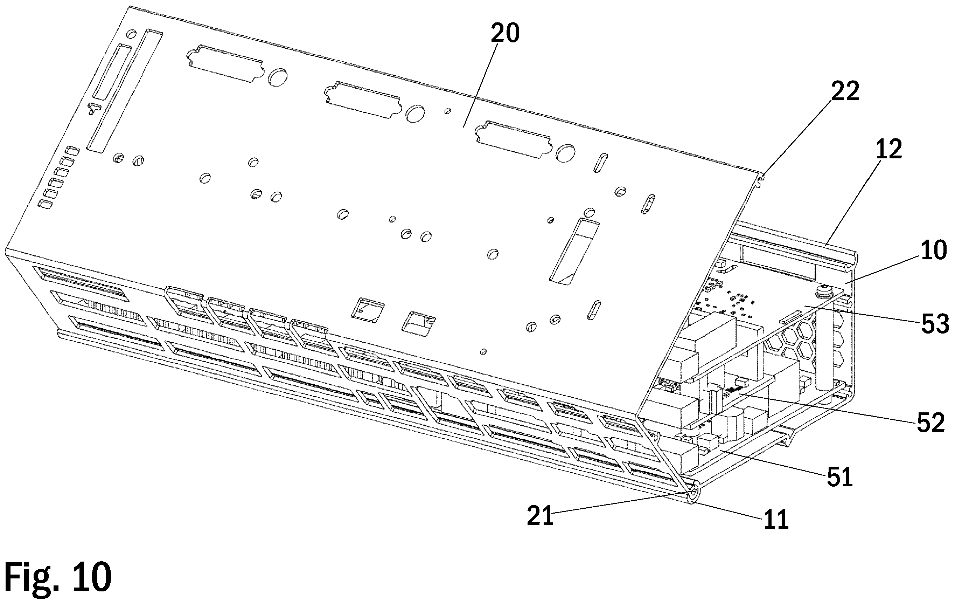

Figure 10 illustrates a perspective front view of a base enclosure part with assembled electronics components and a cover enclosure part of the electronics enclosure joined from the hinge according to one embodiment of the present invention. In the presented embodiment, the base enclosure part 10 of the electronics enclosure comprises a first hinge joint part 11 and a first snap joint part 12. Respectively, in the presented embodiment, the cover enclosure part 20 of said electronics enclosure comprises a second hinge joint part 21 and a second snap joint part 22. In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. In the presented embodiment, electronics components have been assembled to the base enclosure part 10. In the presented embodiment, said assembled electronics components 51-53 comprise one or more circuit boards 51-53 and other electronics components assembled on said one or more circuit boards 51 - 53.

As shown in Figure 10, the second hinge joint part 21 of the cover enclosure part 20 is joined with the first hinge joint part 11 of the base enclosure part 10. The cover enclosure part 20 is now supported to the base enclosure part 10 from the hinge joint 11, 21 so that the cover enclosure part 20 can now be turned in relation to the base enclosure part 10.

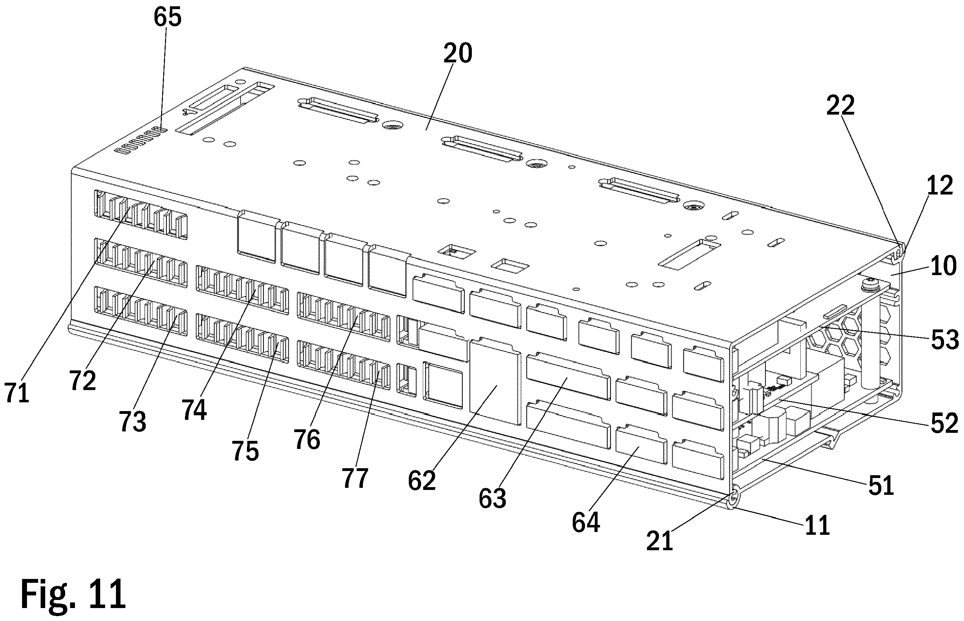

Figure 11 illustrates a perspective front view of a base enclosure part with assembled electronics components and a cover enclosure part of the electronics enclosure joined from the hinge and snapped together according to one embodiment of the present invention. In the presented embodiment, the base enclosure part 10 of said electronics enclosure comprises a first hinge joint part 11 and a first snap joint part 12. Respectively, in the presented embodiment, the cover enclosure part 20 of said electronics enclosure comprises a second hinge joint part 21 and a second snap joint part 22. In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint.

In the presented embodiment, electronics components 51-53, 62-65, 71-77 have been assembled to the base enclosure part 10. Said assembled electronics components 51-53, 62-65, 71-77 may comprise one or more circuit boards 51-53 and other electronics components 62-65, 71-77 assembled on said one or more circuit boards 51-53. Said other electronics components 62-65, 71-77 may comprise one or more high thermal load components having a high thermal load. Said other electronics components 62-65, 71-77 may comprise one or more heatsink-equipped components 71-77 being equipped with a heatsink. Said other electronics components 62-65, 71-77 may comprise one or more indicator lights 65 and/or light guides 65 of the electronics.

As shown in Figure 11, the second hinge joint part 21 of the cover enclosure part 20 is joined with the first hinge joint part 11 of the base enclosure part 10. Furthermore, the cover enclosure part 20 is turned in relation to the base enclosure part 10 and said enclosure parts 10, 20 are snapped together by joining said first snap joint part 12 and said second snap joint part 22 together.

One portion of said other electronics components 62-65, 71-77 may comprise indicator lights 65 and/or light guides 65 fitted for openings 29 for indicator lights and/or light guides of the electronics. Another portion of said other electronics components 62-65, 71-77 may comprise particular electronics components 62-64 fitted for openings 24-26 for cooling of said particular electronics components 62-64. A third portion of said other electronics components 62-65, 71-77 may comprise one or more heatsink-equipped components 71-77 fitted for connecting via openings 27 to said cover enclosure part 20 for conducting the heat from the heatsink-equipped components 71-77 to said cover enclosure part 20.

The base enclosure part 10 and the cover enclosure part 20 of said electronics enclosure are now assembled together to form an electronics enclosure assembly of the base enclosure part 10 and the cover enclosure part 20. The first side enclosure part 30 and the second side enclosure part 40 can now be fastened with screws 31, 41 to said electronics enclosure assembly of base enclosure part 10 and cover enclosure part 20.

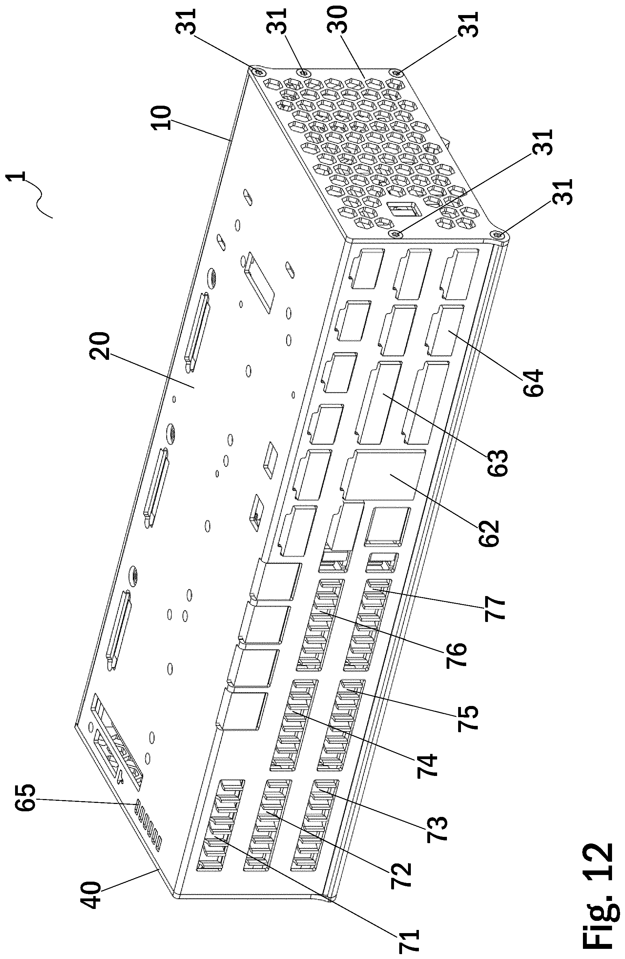

Figure 12 illustrates a perspective front view of an electronics enclosure with assembled electronics components according to one embodiment of the present invention. In the presented embodiment, electronics components 62-65, 71-77 have been assembled to the base enclosure part 10. Said assembled electronics components 62-65, 71-77 may comprise one or more circuit boards and other electronics components 62-65, 71-77 assembled on said one or more circuit boards. Said other electronics components 62-65, 71-77 may comprise one or more high thermal load components having a high thermal load. Said other electronics components 62-65, 71-77 may comprise one or more heatsink-equipped components 71-77 being equipped with a heatsink. Said other electronics components 62-65, 71-77 may comprise one or more indicator lights 65 and/or light guides 65 of the electronics.

In the presented embodiment, the base enclosure part 10 and the cover enclosure part 20 of said electronics enclosure 1 are now assembled together to form an electronics enclosure assembly of the base enclosure part 10 and the cover enclosure part 20. Furthermore, the first side enclosure part 30 and the second side enclosure part 40 are fastened with screws 31 to said electronics enclosure assembly of base enclosure part 10 and cover enclosure part 20. In the presented embodiment, the electronics enclosure 1 consists of two extruded profile parts and two side enclosure parts. In the perspective front view Figure 12, the cover enclosure part 20 and a first side enclosure part 30 of said electronics enclosure 1 can be seen.

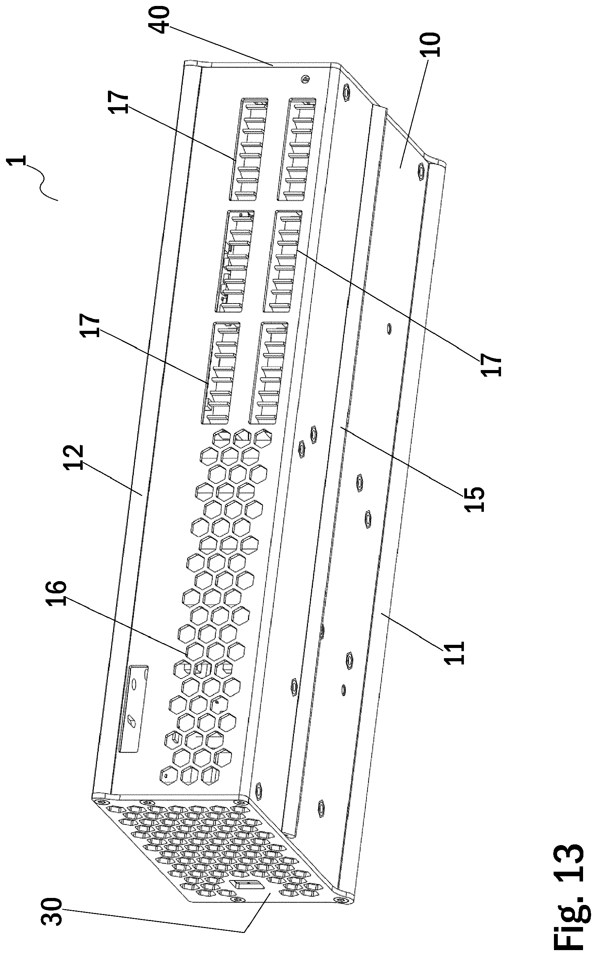

Figure 13 illustrates a perspective rear view of an electronics enclosure with assembled electronics components according to one embodiment of the present invention. In the presented embodiment, electronics components have been assembled to the base enclosure part 10 of said electronics enclosure 1. Said assembled electronics components may comprise one or more circuit boards and other electronics components assembled on said one or more circuit boards. Said other electronics components may comprise one or more high thermal load components having a high thermal load. Said other electronics components may comprise one or more heatsink-equipped components being equipped with a heatsink.

The base enclosure part 10 of said electronics enclosure 1 may comprise one or more openings 16, 17. Said one or more openings 16, 17 of the base enclosure part 10 may comprise openings 16, 17 for cooling of the electronics boards and the electronics components. Said one or more openings 16, 17 of the base enclosure part 10 may comprise openings for switches and/or connectors of the electronics. One portion of said one or more openings 16, 17 may comprise openings fitted for cooling of particular electronics components. Another portion of said one or more openings 16, 17 may comprise openings 17 fitted for connecting one or more heatsink-equipped components to said base enclosure part 10 for conducting the heat from the heatsink-equipped components to said base enclosure part 10. Furthermore, base enclosure part 10 of said electronics enclosure 1 according to the presented embodiment also comprises a mounting protrusion 15, preferably a DIN-rail mounting protrusion 15, for facilitating easy mounting of said electronics enclosure 1.

In the presented embodiment, the base enclosure part 10 and the cover enclosure part 20 of said electronics enclosure 1 are now assembled together to form an electronics enclosure assembly of the base enclosure part 10 and the cover enclosure part 20. Furthermore, the first side enclosure part 30 and the second side enclosure part 40 are fastened with screws 31 to said electronics enclosure assembly of base enclosure part 10 and cover enclosure part 20. In the presented embodiment, the electronics enclosure 1 consists of two extruded profile parts and two side enclosure parts. In the perspective rear view Figure 13, the base enclosure part 10 and a first side enclosure part 30 of said electronics enclosure 1 can be seen.

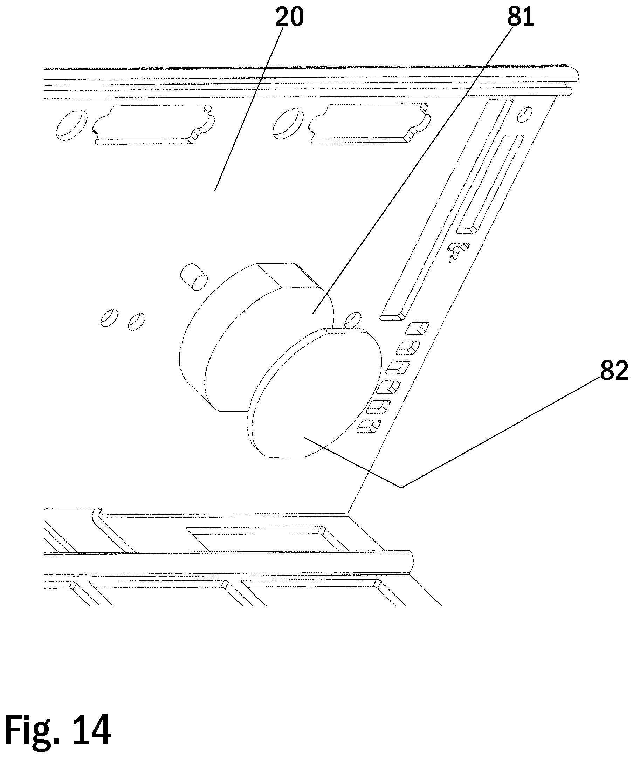

Figure 14 illustrates a detailed view of a base enclosure part of the electronics enclosure with exploded view parts of a thermal interface arrangement according to one embodiment of the present invention. In Figure 14, a cover enclosure part 20 according to one embodiment of the present invention is shown. Furthermore, a thermal interface cylinder 81 and a first thermal interface sheet 82 of a thermal interface arrangement according to one embodiment of the present invention is shown.

In the embodiment of the present invention, said thermal interface cylinder 81 may be connected to said cover enclosure part 20 or to a base enclosure part 10, e.g. with a snap connection or a screw connection. Said thermal interface cylinder 81 may be made of thermal conductive material, e.g. aluminium or aluminium alloy.

Said first thermal interface sheet 82 may be adhered to said thermal interface cylinder 81, e.g. with a glue, paste, or adhesive. Said first thermal interface sheet 82 may be a specially manufactured TIM-sheet (TIM, Thermal Interface Material) of thermal conductive material. Instead of or in addition to said first thermal interface sheet 82 thermal grease may be applied to said cover enclosure part 20 or to said base enclosure part 10.

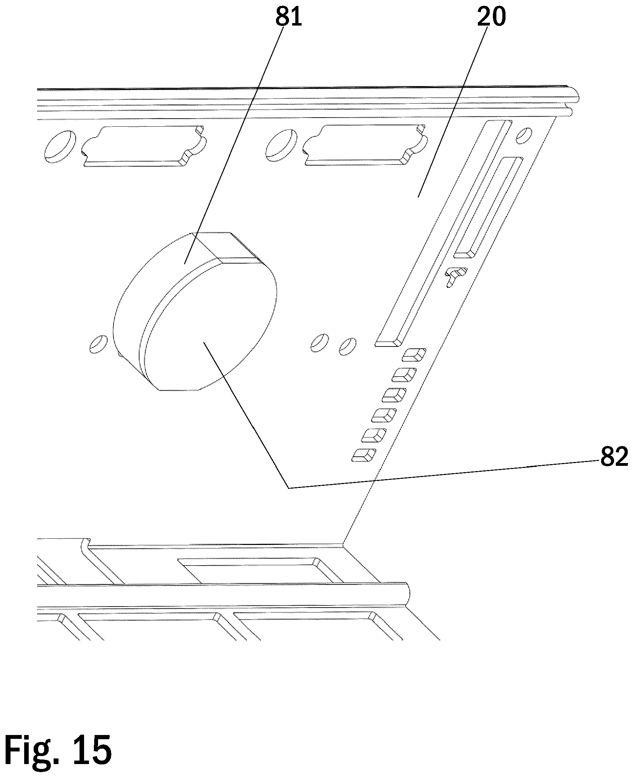

Figure 15 illustrates a detailed view of a base enclosure part of the electronics enclosure with an assembled thermal interface arrangement according to one embodiment of the present invention. In the presented embodiment, a thermal interface cylinder 81 is connected to a cover enclosure part 20 according to one embodiment of the present invention. Said thermal interface cylinder 81 may be connected to said cover enclosure part 20 or to a base enclosure part 10, e.g. with a snap connection or a screw connection. Said thermal interface cylinder 81 may be made of thermal conductive material, e.g. aluminium or aluminium alloy. Furthermore, in the presented embodiment, a first thermal interface sheet 82 is adhered to said thermal interface cylinder 81. Said first thermal interface sheet 82 may be adhered to said thermal interface cylinder 81, e.g. with a glue, paste, or adhesive. Said first thermal interface sheet 82 may be a specially manufactured TIM-sheet (TIM, Thermal Interface Material) of thermal conductive material. Instead of or in addition to said first thermal interface sheet 82 thermal grease may be applied to said cover enclosure part 20 or to said base enclosure part 10.

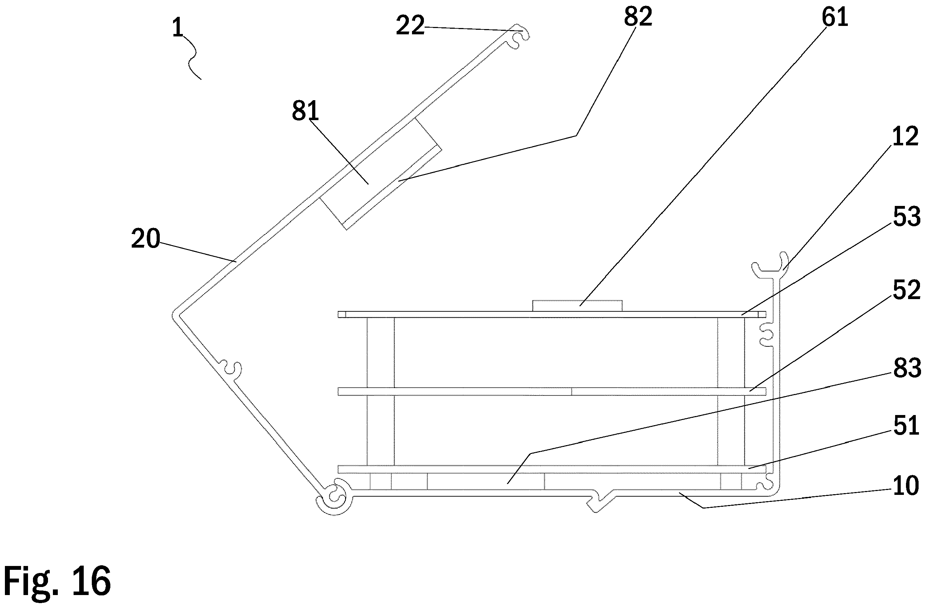

Figure 16 illustrates a side view of a base enclosure part with assembled electronics components and a cover enclosure part with an assembled thermal interface arrangement of the electronics enclosure joined from the hinge according to one embodiment of the present invention.

In the presented embodiment, a thermal interface cylinder 81 is connected to a cover enclosure part 20 according to one embodiment of the present invention. Said thermal interface cylinder 81 may be connected to said cover enclosure part 20 of said electronics enclosure 1, e.g. with a snap connection or a screw connection. Said thermal interface cylinder 81 is arranged to conduct heat away from a high thermal load component 61 to said cover enclosure part 20. Said thermal interface cylinder 81 may be made of thermal conductive material, e.g. aluminium or aluminium alloy. Furthermore, in the presented embodiment, a first thermal interface sheet 82 is adhered to said thermal interface cylinder 81. Said first thermal interface sheet 82 may be adhered to said thermal interface cylinder 81, e.g. with a glue, paste, or adhesive.

In the presented embodiment, a second thermal interface sheet 83 is adhered to a base enclosure part 10. Said second thermal interface sheet 83 is arranged to conduct heat away from a circuit board 51 to said base enclosure part 10. Said second thermal interface sheet 83 may be adhered to said base enclosure part 10, e.g. with a glue, paste, or adhesive. Said first and second thermal interface sheet 82, 83 may be a specially manufactured TIM-sheet (TIM, Thermal Interface Material) of thermal conductive material. Instead of or in addition to said first and second thermal interface sheet 82, 83 thermal grease may be applied to said cover enclosure part 20 or to said base enclosure part 10.

In an embodiment of the present invention, a thermal interface cylinder 81 and/or a thermal interface sheet 82, 83 may be connected between a cover enclosure part 20 or a cover enclosure part 10 and a circuit board or a high thermal load component. A thermal interface cylinder 81 may be connected to a cover enclosure part 20 or to a base enclosure part 10, e.g. with a snap connection or a screw connection. Said thermal interface cylinder 81 may be arranged to conduct heat away from assembled electronics components 51-53, 61 to said cover enclosure part 20 or to said base enclosure part 10. A thermal interface cylinder 81 may be made of thermal conductive material, e.g. aluminium or aluminium alloy. Furthermore, in an embodiment, a thermal interface sheet 82, 83 may be adhered to a cover enclosure part 20, to a cover enclosure part 10, to a circuit board or to a high thermal load component. Said thermal interface sheet 82, 83 may be adhered e.g. with a glue, paste, or adhesive. Said thermal interface sheet 82, 83 may be arranged to conduct heat away from assembled electronics components 51-53, 61 to said cover enclosure part 20 or to said base enclosure part 10. Said thermal interface sheet 82, 83 may be a specially manufactured TIM-sheet (TIM, Thermal Interface Material) of thermal conductive material. Instead of or in addition to said thermal interface sheet 82, 83 thermal grease may be applied to said cover enclosure part 20 or to said base enclosure part 10.

In the presented embodiment, the base enclosure part 10 comprises a first snap joint part 12 and the cover enclosure part 20 comprises a second snap joint part 22. In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. In the presented embodiment, electronics components have been assembled to the base enclosure part 10. In the presented embodiment, said assembled electronics components 51-53, 61 comprise one or more circuit boards 51-53 and other electronics components 61 assembled on said one or more circuit boards 51-53. In the presented embodiment, said assembled electronics components 51-53, 61 comprise a high thermal load component 61 having a high thermal load. Said high thermal load component 61 may e.g. be a processor 61 and/or power supply related component.

As shown in Figure 16, the cover enclosure part 20 is supported to the base enclosure part 10 from the hinge joint so that the cover enclosure part 20 can now be turned in relation to the base enclosure part 10.

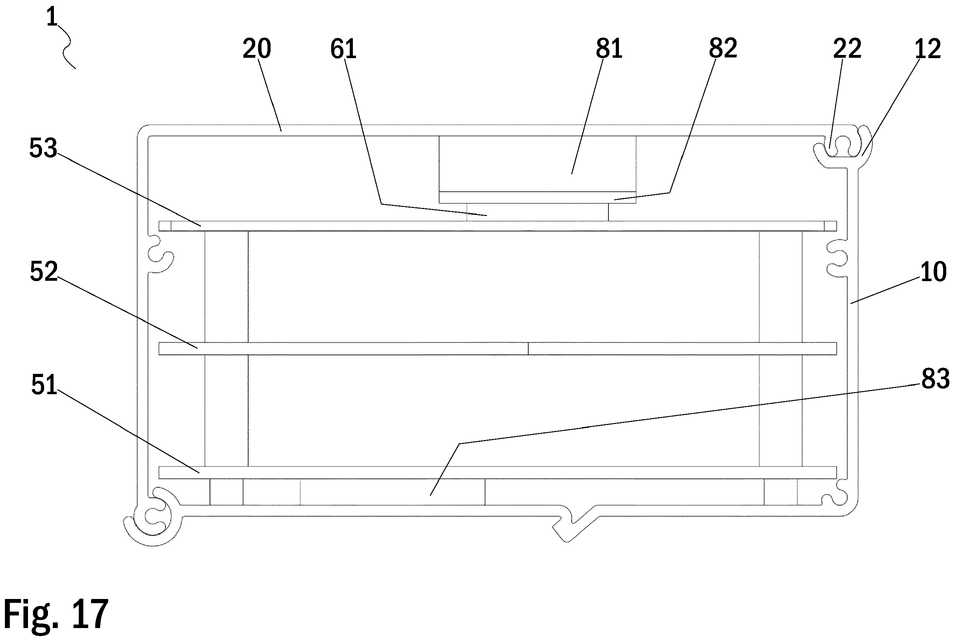

Figure 17 illustrates a side view of a base enclosure part with assembled electronics components and a cover enclosure part with an assembled thermal interface arrangement of the electronics enclosure joined from the hinge and snapped together according to one embodiment of the present invention. In the presented embodiment, a thermal interface cylinder 81 is connected to a cover enclosure part 20 of said electronics enclosure 1 according to one embodiment of the present invention. Said thermal interface cylinder 81 may be connected to said cover enclosure part 20, e.g. with a snap connection or a screw connection. Furthermore, in the presented embodiment, a first thermal interface sheet 82 is adhered to said thermal interface cylinder 81. Said first thermal interface sheet 82 may be adhered to said thermal interface cylinder 81, e.g. with a glue, paste, or adhesive.

In the presented embodiment, a second thermal interface sheet 83 is connected to a base enclosure part 10. Said second thermal interface sheet 83 is arranged to conduct heat away from a circuit board 51 to said base enclosure part 10. Said second thermal interface sheet 83 may be adhered to said base enclosure part 10, e.g. with a glue, paste, or adhesive. Said first and second thermal interface sheet 82, 83 may be a specially manufactured TIM-sheet (TIM, Thermal Interface Material) of thermal conductive material. Instead of or in addition to said first and second thermal interface sheet 82, 83 thermal grease may be applied to said cover enclosure part 20 or to said base enclosure part 10.

In the presented embodiment, the base enclosure part 10 of said electronics enclosure 1 comprises a first snap joint part 12. Respectively, in the presented embodiment, the cover enclosure part 20 of said electronics enclosure 1 comprises a second snap joint part 22. In the presented embodiment, the first hinge joint part 11 matches with the second hinge joint part 21, so that said first hinge joint part 11 and said second hinge joint part 21 together form a detachable hinge joint. In the presented embodiment, the first snap joint part 12 matches with the second snap joint part 22, so that said first snap joint part 12 and said second snap joint part 22 together form an openable/closable snap joint. In the presented embodiment, electronics components have been assembled to the base enclosure part 10. In the presented embodiment, said assembled electronics components 51-53, 61 comprise one or more circuit boards 51-53 and other electronics components 61 assembled on said one or more circuit boards 51-53. In the presented embodiment, said assembled electronics components 51-53, 61 comprise a high thermal load component 61 having a high thermal load. Said high thermal load component 61 may e.g. be a processor 61 and/or power supply related component.

As shown in Figure 17, the cover enclosure part 20 is turned in relation to the base enclosure part 10 and said enclosure parts 10, 20 are snapped together by joining said first snap joint part 12 and said second snap joint part 22 together. Said thermal interface arrangement of the cover enclosure part with an assembled of the electronics enclosure 1 may be assembled so that as said cover enclosure part 20 and said base enclosure part 10 are snapped together, said first thermal interface sheet 82 comes to a contact with said high thermal load component 61. Said first thermal interface sheet 82 and said thermal interface cylinder 81 are now connected to said high thermal load component 61 and conduct the heat from said high thermal load component 61 to said cover enclosure part 20.

The electronics enclosure 1 according to the present invention provides a robust and light protective casing for electronics of an electric device. The hinged design of the electronics enclosure 1 makes assembling of the electronics enclosure unit 1 simpler and faster. The service and maintenance of the electronics enclosure 1 according to the present invention is also more convenient, simpler and faster.

The electronics enclosure 1 according to the present invention acts as a heatsink as the thermal losses from assembled electronics components are conducted to extruded profile parts of said base enclosure part 10 and said cover enclosure part 20. Extruded profile parts according to the present invention are somewhat inexpensive and also reduce the need for additional parts.

The electronics enclosure 1 according to the present invention may be used to protect a control unit of an electric device. With the help of the electronics enclosure 1 according to the present invention the functionality of the control unit of an electric device is better ensured and the reliability of the electric device is better secured.

The electronics enclosure 1 according to the present invention provides a robust mechanical encasing for the electronics of an electric device. An electronics enclosure according to the present invention gives a physical and an electromagnetic protection for the electronics of an electric device and provides mechanical support and adequate cooling for the circuit boards and high thermal load components of an electric device.

The robust mechanical structure of the electronics enclosure 1 according to the present invention increases the vibration durability of the electric device. Compared to the prior art steel sheet electronics enclosure the aluminium alloy profile parts of the electronics enclosure 1 are much stiffer, lighter and amplify vibrations less.

The electronics enclosure 1 according to the present invention also provides a proper thermal management of components having high thermal load. Such components are related to, for example, processor and power supply. With the help of the present invention, some high thermal load components are thermally coupled to extruded profile parts of said base enclosure part 10 and said cover enclosure part 20, thus helping the thermal management of an electric device.

The electronics enclosure 1 according to the present invention is very easy to assemble to the electric device. The extruded profile parts of the electronics enclosure 1 have a hinge fitting in one corner and a snap-fit in the opposite corner. This allows the circuit boards to be assembled onto one profile and the other profile to be rotated in the hinge and snapped into place, making assembly process most simple. The rotating motion allowed by the hinge during the assembly provides a quick and easy assembly. The connectors come through the panel of the rotating profile during rotation. It is also clear for the assembler when the profile is in place, as the profile snaps visibly in place. The cover enclosure part 20 of the electronics enclosure 1 according to the present invention is pivotably connectable to the base enclosure part 10 and detachable from said base enclosure part 10. This makes the assembly process and the service and maintenance of the electric device a lot easier. The electronics enclosure 1 according to the present invention can be used for shielding the electronics of any kind of device, e.g. electric device, such as an electric drive device or any other electric device with electronics.

It is to be understood that the above description and the accompanying Figures are only intended to teach the best way known to the inventors to make and use the invention. It will be apparent to a person skilled in the art that the inventive concept can be implemented in various ways. The above-described embodiments of the invention may thus be modified or varied, without departing from the invention, as appreciated by those skilled in the art in light of the above teachings. It is therefore to be understood that the invention and its embodiments are not limited to the examples described above but may vary within the scope of the claims and their equivalents.

## Claims

1. An electronics enclosure (1), comprising:
- a cover enclosure part (20);
- a base enclosure part (10); and
- a first side enclosure part (30) and a second side enclosure part (40),
- wherein said base enclosure part (10) and said cover enclosure part (20) are extruded profile parts, and
- wherein said cover enclosure part (20) is pivotably connectable to said base enclosure part (10) and detachable from said base enclosure part (10).

2. An electronics enclosure (1) according to claim 1, wherein said first side enclosure part (30) and said second side enclosure part (40) are fastenable to said base enclosure part (10) and to said cover enclosure part (20) with screws (31), (41).

3. An electronics enclosure (1) according to claim 2, wherein said base enclosure part (10) and/or said cover enclosure part (20) comprise one or more groove parts (11-14), (21-23) for fastening said first side enclosure part (30) and/or said second side enclosure part (40).

4. An electronics enclosure (1) according to any of the claims 1-3, wherein said base enclosure part (10) comprises a first hinge joint part (11) and said cover enclosure part (20) comprises a matching second hinge joint part (21) so that said first hinge joint part (11) and said second hinge joint part (21) together form a detachable hinge joint.

5. An electronics enclosure (1) according to any of the claims 1-4, wherein said base enclosure part (10) comprises a first snap joint part (12) and said cover enclosure part (20) comprises a matching second snap joint part (22) so that said first hinge joint part (12) and said second hinge joint part (22) together form an openable/closable snap joint.

6. An electronics enclosure (1) according to any of the claims 1-5, wherein said base enclosure part (10) is arranged for assembling of electronics components (51-53), (61-64), (71-77).

7. An electronics enclosure (1) according to claim 6, wherein said electronics components (51-53), (61-64), (71-77) comprise one or more circuit boards (51-53) and other electronics components (61-64, 71-77) assemblable on said one or more circuit boards (51-53).

8. An electronics enclosure (1) according to claim 6 or to claim 7, wherein said base enclosure part (10) and/or said cover enclosure part (20) comprise one or more openings (16), (17), (24-29).

9. An electronics enclosure (1) according to claim 8, wherein said one or more openings (16), (17), (24-29) comprise openings (16), (17), (24-28) for cooling of said one or more circuit boards (51-53) and/or said other electronics components (61-64, 71-77).

10. An electronics enclosure (1) according to claim 8 or to claim 9, wherein said one or more openings (16), (17), (24-29) comprise openings (28) for switches and/or connectors and/or openings (29) for indicator lights and/or light guides of said electronics components (51-53), (61-64), (71-77).

11. An electronics enclosure (1) according to any of the claims 8-10, wherein said one or more openings (16), (17), (24-29) comprise openings (24-26) fitted for cooling of particular electronics components (62-64).

12. An electronics enclosure (1) according to any of the claims 8-11, wherein said one or more openings (16), (17), (24-29) comprise openings (17), (27) fitted for connecting one or more heatsink-equipped components to said base enclosure part (10) and/or said cover enclosure part (20) for conducting heat from said one or more heatsink-equipped components to said base enclosure part (10) and/or said cover enclosure part (20).

13. An electronics enclosure (1) according to any of the claims 6-12, wherein an at least one thermal interface cylinder (81) is connected to said cover enclosure part (20) and/or to said base enclosure part (10) for conducting heat from said electronics components (51-53), (61-64), (71-77) to said cover enclosure part (20) and/or to said base enclosure part (10).

14. An electronics enclosure (1) according to any of the claims 6-13, wherein an at least one thermal interface sheet (82), (83) and/or thermal grease is adhered/applied to said thermal interface cylinder (81) and/or to said cover enclosure part (20) and/or to said base enclosure part (10).

15. An electronics enclosure (1) according to any of the claims 1-14, wherein said base enclosure part (10) comprises a mounting protrusion (15).
